# EUROPEAN PATENT APPLICATION

(11) **EP 1 950 177 A1**
(43) Date of publication of application: **30.07.2008**
(21) Application number: 06832726.1
(22) Date of filing: 16.11.2006
(51) Int. Cl.: C01G 15/00, H01L 29/786

(54) **SEMICONDUCTOR THIN FILM, METHOD FOR PRODUCING SAME, AND THIN FILM TRANSISTOR**

(30) Priority: 18.11.2005 JP 2005334500
(71) Applicant: Idemitsu Kosan Co., Ltd., Chiyoda-ku Tokyo 100-8321 (JP)
(72) Inventor: YANO, Koki, Sodegaura-shi Chiba 299-0293 (JP); INOUE, Kazuyoshi, Sodegaura-shi Chiba 299-0293 (JP); SHIMANE, Yukio, Sodegaura-shi Chiba 299-0293 (JP); SHIBUYA, Tadao, Sodegaura-shi Chiba 299-0293 (JP); YOSHINAKA, Masahiro, Sodegaura-shi Chiba 299-0293 (JP)
(74) Representative: Gille Hrabal Struck Neidlein Prop Roos
(86) International application number: PCT/JP2006/322837
(87) International publication number: WO 2007/058248

(57) **Abstract**

A transparent semiconductor thin film 40 having low carrier concentration and a large energy band gap is produced by forming a thin film which contains indium oxide and an oxide of a positive divalent element, and then oxidizing or crystallizing the thin film.

## Description

### Technical Field

The present invention relates to a semiconductor thin film containing indium, positive divalent element, and oxygen, a method for producing the same, and a thin film transistor using such a semiconductor thin film.

### Background Art

A field effect transistor is widely used as a unit electronic device of a semiconductor memory integrated circuit, a high-frequency signal amplification device, a liquid crystal drive device, or the like and is an electronic device which is most practically used at present.
Among the devices, with remarkable development of displays in recent years, a thin film transistor (TFT) is often used as a switching device for driving a display by applying a drive voltage to a display device in not only a liquid crystal display (LCD) but also various displays such as an electroluminescence display (EL) and a field emission display (FED).
As the material of the thin film transistor, a silicon semiconductor compound is used most widely. Generally, silicon single crystal is used for an RF amplification device, a device for an integrated circuit, and the like requiring high-speed operation. Amorphous silicon is used for a liquid crystal driving device or the like to address a demand for a larger area.

However, at the time of crystallizing a crystalline silicon thin film, a high temperature such as 800°C or higher is necessary, so that it is difficult to form the crystalline silicon thin film on a glass substrate or an organic substrate. There are consequently problems such that a crystalline silicon thin film can be formed only on an expensive substrate having high heat resistance such as silicon wafer, quartz, or the like, and enormous energy and a number of processes are required for manufacture.
In addition, in the case of using a crystalline silicon thin film, normally, the device configuration of a TFT is limited to a top gate configuration. Consequently, it is difficult to decrease the cost by reducing the number of masks or the like.

On the other hand, an amorphous silicon semiconductor (amorphous silicon) which can be formed at a relatively low temperature has a switching speed lower than that of a crystalline one. Therefore, when the amorphous silicon semiconductor is used as a switching device for driving a display, there is the case that the semiconductor cannot follow high speed display of a moving picture.
Further, when a semiconductor active layer is irradiated with a visible ray, it becomes conductive. There is the possibility such that a leak current is generated, and an erroneous operation is performed. A problem occurs such that the characteristics of the switching device deteriorate. There is known a method of providing a light shield layer for blocking the visible ray to address the problem. As the light shield layer, for example, a metal thin film is used.
However, when the light shield layer which is a metal thin film is provided, the number of processes increases and, in addition, floating potential is generated. It is consequently necessary to set the light shield layer to the ground level. In this case as well, a problem occurs such that parasitic capacitance is generated.

At present, as the switching device for driving the display, a device using a silicon semiconductor film is the mainstream for the reasons that various performances of silicon thin films such as high stability, high processibility, and high switching speed are excellent. Such silicon thin films are manufactured generally by chemical vapor deposition (CVD) method.
There is a conventional thin film transistor (TFT) having an inversely-staggered structure in which a gate electrode, a gate insulating layer, a semiconductor layer made of amorphous silicon hydride (a-Si:H) or the like, and source and drain electrodes are stacked on a substrate made of glass or the like. In the field of a large-area device such as an image sensor, the conventional thin film transistor is used as a drive device of a flat panel display or the like typified by a liquid crystal display of an active matrix type. In those uses, as the functions become higher also in a conventional device made of amorphous silicon, higher operation speed is in demand.

Under such circumstances, in recent years, attention is being paid to a transparent semiconductor thin film made of a metallic oxide, particularly, a transparent semiconductor thin film made of a zinc oxide crystal as a film having stability higher than that of the silicon semiconductor thin film.
For example, a method of constructing a thin film transistor by crystallizing a zinc oxide at high temperature is described in Patent Documents 1 and 2, or the like. Non-patent document 1 describes a method of generating an amorphous transparent semiconductor film made of indium oxide, gallium oxide, or zinc oxide on a resin substrate by PLD (Pulse Laser Deposition) method and driving a thin film transistor.

Hitherto, a transparent conductive film containing an indium oxide and an oxide of a positive divalent element is known (refer to, for example, Patent Document 3). However, in such a transparent conductive film, a positive divalent element such as zinc is contained just for the purpose of improving carrier density, facilitating wet etching, or the like. An attempt is not made to decrease carrier density and drive a thin film transistor by using a positive divalent element as a dopant to control the carrier density to be low.
Patent document 1: Japanese Unexamined Patent Application Publication No. 2003-86808
Patent document 2: Japanese Unexamined Patent Application Publication No. 2004-273614
Patent Document 3: Japanese Unexamined Patent Application Publication No. H07-235219
Non-Patent Document 1: NATURE vol. 432 25 NOVEMBER 2004; p 488-492

### Disclosure of the Invention

### Problems to be solved by the invention

However, a transparent semiconductor thin film obtained by crystallizing a zinc oxide at high temperature among such transparent semiconductor thin films made of metal oxides has a low field effect mobility of about 1 cm²/V·sec and a low on-off ratio. Moreover, leak current tends to occur. It is consequently difficult to practically use the film from the technical viewpoint. A number of examinations have been made on an oxide semiconductor containing crystalline material using zinc oxide. However, in the case of forming a film by sputtering generally industrially used, the following problems occur.
Specifically, there is the possibility that the performances of a TFT deteriorate such that the mobility becomes low, the on-off ratio becomes low, the leak current increases, the pinch-off is unclear, and the device tends to be normally on. In addition, since the chemical resistance is low, there are limits in manufacturing processes and use environments such that it is difficult to perform wet etching. Further, in order to improve the performances, a film has to be formed under high pressure. Consequently, there are also technical problems such that the film forming speed is low and high-temperature process of 700°C or higher is necessary. The TFT performances such as field mobility are low in a bottom-gate configuration. To improve the performances, the film thickness has to be set to 50 nm or more in a top-gate configuration. There is also a limit in the TFT device configuration.

In the transparent semiconductor thin film made of an amorphous material, a change with time in the characteristics and a thermal change are large. Consequently, there are problems such as a large change in threshold voltage in long-time use. Particularly, in a process of a liquid crystal panel, there is a case that heat of 250°C or higher or, sometimes, 300°C or higher is used. The thermal change in the characteristics is a large hindrance in industrialization. The reason is estimated as follows. The number of carriers is too large, an amorphous material is used or oxygen is contained forcedly by rising oxygen partial pressure at the time of film formation. Therefore, oxygen moves easily, and the carrier density changes easily.
Since a large amount of oxygen is introduced at the time of film formation, it is difficult to control the transparent semiconductor thin film made of an amorphous material, and a change with time of the carrier density and a change according to the ambient temperature tend to occur. It is therefore necessary to precisely control the oxygen partial pressure at the time of film formation. The film has problems in reproducibility, stability, and uniformity in large area at the time of industrialization. It is difficult to apply the film to a large liquid crystal display and the like.
Further, since the material is amorphous, the chemical resistance to an etchant typified by PAN and the like is low. The film has drawbacks such that a metallic wire on a semiconductor film cannot be subject to wet etching, flexibility is high, and transmittance of a multilayer film tends to drop. Since the material is amorphous, there is also the possibility that the film absorbs oxygen, water, and the like in atmospheric gas, the electric characteristics of the film change, and the yield decreases.

On the other hand, an oxygen defect tends to occur in a film containing a crystalline material of indium oxide, particularly, a polycrystal film. Even if the oxygen partial pressure at the time of film formation is increased, or the oxidizing process or the like is performed, it is considered to be difficult to set the carrier density to be less than 2×10⁺¹⁷ cm⁻³. Consequently, an attempt to use the film as a semiconductor film or TFT has hardly been made.

The present invention has been achieved in consideration of the circumstances. An object of the invention is to provide a semiconductor thin film containing indium, a positive divalent element, and oxygen, and having low carrier concentration, high Hall mobility, and a large energy band gap, a method for manufacturing the semiconductor thin film, and a thin film transistor using the semiconductor thin film, and having high heat resistance, high chemical resistance, a small amount of a shift in a threshold in a long-time use, moreover, a high field mobility, a high on-off ratio, and improved device characteristics obtained by reducing the influence of radiation light such as occurrence of a leak current.

### Means for solving the problems

A semiconductor thin film according to the present invention for solving the problems is a thin film containing indium, a positive divalent element, and oxygen and whose specific resistance obtained by a four-terminal method is 10⁻¹ Ωm to 10⁸ Ωm.
It is assumed that the specific resistance of the transparent semiconductor thin film 40 is measured under temperature environments around the room temperature, and a temperature around the room temperature lies in a temperature range of 0 to about 40°C.

With such a configuration, by using the semiconductor thin film according to the present invention, a novel excellent field effect transistor can be obtained, realizing high field effect mobility, a high on-off ratio, a clear pinch-off, and a larger area replacing a conventional field effect transistor using amorphous silicon. The transistor obtained in such a manner can be formed on a substrate made of a material whose heat resistance temperature is limited such as non-alkali glass.
When the specific resistance is lower than 10⁻¹ Ωcm, electricity flows easily, and the film may not function as a semiconductor thin film.
On the other hand, when the specific resistance is higher than 10⁸ Ωcm, the film may not function as a semiconductor unless a strong electric field is applied.
In the semiconductor thin film according to the present invention, the carrier concentration is reduced by using the positive divalent element, and the carrier concentration can be controlled by concentration of the positive divalent element. Consequently, as compared with the case of controlling the carrier density by oxygen partial pressure at the time of film formation, higher uniformity, stability, and reproducibility is realized.

In the semiconductor thin film according to the invention, preferably, carrier density at around the room temperature is less than 2×10⁺¹⁷ cm⁻³, more preferably, 10⁺¹⁷ cm⁻³ or less.
When the carrier density becomes equal to or higher than 2×10⁺¹⁷ cm⁻³, there is the possibility that the device does not drive as a TFT. Even if the device drives as a TFT, it is feared that the device is normally on, threshold voltage becomes high, the on-off ratio becomes low, and leak current increases.

In the semiconductor thin film according to the invention, the positive divalent element is preferably one or more elements selected from zinc, magnesium, copper, cobalt, nickel, and calcium. Therefore, the carrier concentration can be controlled efficiently.

In the semiconductor thin film according to the invention, preferably, an energy band gap between a conduction band and a valence band is 2.8 eV or more. Therefore, inconveniences such that electrons in the valence band are excited by being irradiated with visible light and leak current flows easily can be effectively avoided.

The semiconductor thin film according to the invention is preferably a film containing crystalline material. By using a crystalline material for at least a part or all of the semiconductor thin film, as compared with the case of making the semiconductor thin film of an amorphous material, the carrier concentration can be reduced/controlled more easily. In addition, at the time of constructing a transistor, the operation is stabilized more. Consequently, a transistor having excellent heat resistance and high durability can be produced.
Although the crystalline material contained in the thin film may be single crystal or polycrystal, a polycrystal film is preferred which can be manufactured easily from the technical viewpoint and formed with a large area. In single crystal, a crack may occur due to bending or a shock during manufacture process or in use. From this viewpoint as well, polycrystal is preferred.

In the semiconductor thin film according to the invention, preferably, atom ratio between indium [In] and a positive divalent element [X] in the thin film is expressed as X/(X+In) = 0.0001 to 0.1.
When the atom ratio [X/(X+In)] is lower than 0.0001, it is feared that the number of carriers cannot be controlled.
On the other hand, when the atom ratio [X/(X+In)] becomes higher than 0.1, there is the possibility that the interface or surface tends to alter and becomes unstable, crystallization temperature becomes high so that crystallization becomes difficult to be carried out and the carrier concentration becomes high, the carrier concentration changes with time, the Hall mobility deteriorates, heat resistance drops, and chemical resistance drops. At the time of driving the transistor, there is the possibility that threshold voltage fluctuates and driving becomes unstable.

Preferably, the semiconductor thin film according to the invention contains bixbite crystal of indium oxide. By employing the bixbite structure, the Hall mobility can be made high. The reason is estimated that the 5S orbital of indium has an edge sharing structure.
Preferably, at least a part of the positive divalent element such as zinc is solid-solution substituted by indium. By solid-solution substituting indium as a positive trivalent with a positive divalent element, it can be expected that the carrier density is lowered effectively.

The present invention also provides a method for manufacturing a semiconductor thin film, including: a film forming step of forming a thin film containing indium oxide and an oxide of a positive divalent element; and an oxidizing or crystallizing step of making a dopant in the thin film function.

According to the method for manufacturing a semiconductor thin film of the present invention, by making an indium oxide contained as a main component in a thin film, high mobility is realized. By controlling content of water or hydrogen in atmospheric gas, mobility can be controlled.
In addition, by making a positive divalent element contained in indium as a positive trivalent element and crystallizing at least a part at the time of or after film formation, the carrier concentration can be lowered stably and uniformly.

In the method for manufacturing a semiconductor thin film according to the invention, in the oxidizing step or crystallizing step, the thin film is subject to heat treatment in the presence or absence of oxygen under conditions of 80 to 650°C and 0.5 to 12,000 minutes.
When the temperature of the heat treatment is lower than 80°C, the treatment effect may not appear or it may take too long time. When the temperature is higher than 650°C, the substrate may be deformed.
If the time of the heat treatment is shorter than 0.5 minute, time to heat to the inside is insufficient and the heat treatment may not be performed sufficiently. When the time is longer than 12,000 minutes, the processing apparatus becomes large and may not be suitable for an industrial application. There is the possibility that the substrate is broken or deformed during the treatment.

In the method for manufacturing a semiconductor thin film according to the invention, in the oxidizing step or crystallizing step, the thin film is subject to heat treatment in the presence or absence of oxygen by a lamp annealer (LA), a rapid thermal annealer (RTA), or a laser annealer. As the oxidizing step or crystallizing step, an ozone process can be performed. In the oxidizing step or crystallizing step, high-frequency waves, electromagnetic waves, ultraviolet rays, plasma, or other energy may be applied.

In the method for manufacturing a semiconductor thin film according to the invention, the thin film may be formed physically at a substrate temperature of 200°C or less in the film forming step.
With such a method, the carrier concentration can be easily controlled to be low.

In the method for manufacturing a semiconductor thin film according to the invention, preferably, the atom ratio between indium [In] and a positive divalent element [X] in the thin film is expressed as x/(X+In) = 0.0001 to 0.1.
When the atom ratio [X/(X+In)] is lower than 0.0001, it is feared that the number of carriers cannot be controlled.
On the other hand, when the atom ratio [X/(X+In)] becomes higher than 0.1, there is the possibility that the interface or surface tends to alter and becomes unstable, and crystallization temperature is high so that crystallization becomes difficult to be carried out. Consequently, it is feared that the heat resistance and chemical resistance decreases, the carrier concentration becomes high, and mobility deteriorates. There is also the possibility that when a transistor is driven, the threshold voltage fluctuates, driving becomes unstable, the pinch off becomes unclear, and the heat resistance and durability deteriorates.

A thin film transistor according to the invention can be constructed by using the semiconductor thin film according to the invention or a semiconductor thin film manufactured by the method for manufacturing a semiconductor thin film according to the invention.

As the configuration of the transistor, any of known configurations such as the bottom-gate, top-gate, bottom-contact, and top-contact structures can be freely used. Particularly, the bottom-gate structure is advantageous for the reason that performances higher than those of TFTs made of amorphous silicon and ZnO are obtained. The bottom-gate structure is preferable for the reason that the number of masks in manufacture can be easily reduced, and the manufacture cost for a use of a large display or the like can be easily reduced.
A TFT of the bottom gate structure has usually a structure that a gate electrode is disposed (formed) and, after that, a semiconductor layer is disposed (formed).

### Effects of the invention

As described above, according to the present invention, by making an indium oxide contained as a main component in a thin film, high mobility can be realized. In addition, by making a positive divalent element contained in indium as a positive trivalent element, the carrier concentration is decreased. By performing the oxidizing process or crystallizing process after film formation, the carrier concentration can be controlled.
As a result, a novel, excellent field effect transistor having high field effect mobility and a high on -off ratio, which is normally off, having a clear pinch off, and realizing a larger area in place of a conventional field effect transistor made of amorphous silicon can be obtained.

### Brief Description of the Drawings

Fig. 1A is an explanatory diagram showing outline of a first embodiment of a thin film transistor according to the invention.
Fig. 2A is an explanatory diagram showing outline of a second embodiment of a thin film transistor according to the invention.
Fig. 3 is an explanatory diagram showing outline of a third embodiment of a thin film transistor according to the invention.
Fig. 4 is an explanatory diagram showing outline of the third embodiment of the thin film transistor according to the invention.

### Description of reference numerals

1 thin film transistor
40 transparent semiconductor thin film

### Best Mode for Carrying Out the Invention

Preferred embodiments of the present invention will be described below.

### [First Embodiment]

A first embodiment of a thin film transistor according to the present invention will be described.

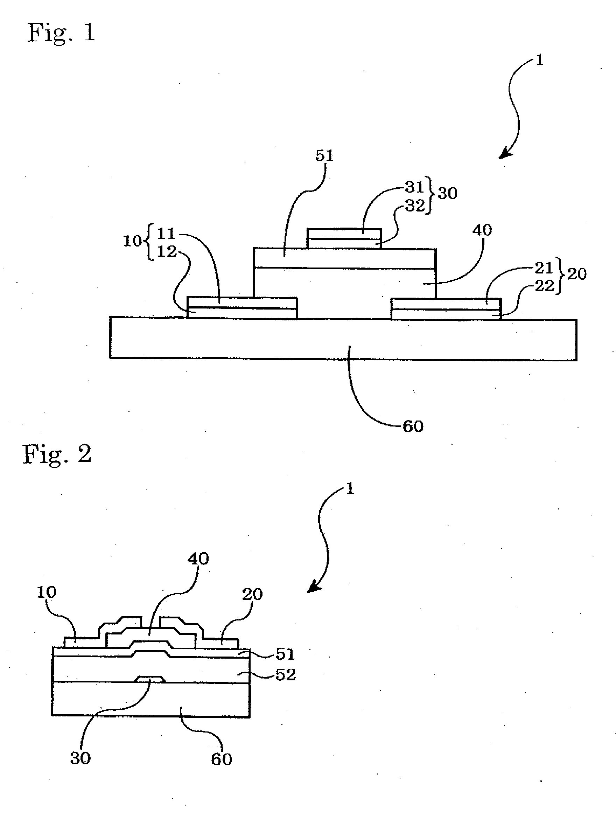

FIG. 1 is an explanatory diagram showing outline of the first embodiment of the thin film transistor according to the invention.

In the example shown in the diagram, in a thin film transistor 1 as a field effect transistor, a drain electrode 10 and a source electrode 20 are formed so as to be apart from each other on a substrate 60, a transparent semiconductor thin film 40 is formed so as to be in contact with at least a part of each of the drain electrode 10 and the source electrode 20, and a gate insulating film 50 and a gate electrode 30 are formed in this order on the transparent semiconductor thin film 40. In such a manner, the thin film transistor 1 is constructed as the thin film transistor 1 of a top gate type.

In the embodiment, the materials of the gate electrode 30, the source electrode 20, and the drain electrode 10 are not particularly limited. Materials generally used can be arbitrarily selected without loosing the effects of the embodiment. For example, a transparent electrode made of ITO, IZO, ZnO, SnO₂, or the like, a metal electrode made of Al, Ag, Cr, Ni, Mo, Au, Ti, Ta, or the like, or a metal electrode made of any of alloys containing the metals can be used.
Each of the gate electrode 30, the source electrode 20, and the drain electrode 10 may have a multilayer structure obtained by stacking two or more different conductive layers. In the example shown in the diagram, the electrodes 30, 20, and 10 are constructed by first conductive layers 31, 21, and 11 and second conductive layers 32, 22, and 12, respectively.

The material of the gate insulating film 50 is not also particularly limited. A material generally used can be arbitrarily selected without loosing the effects of the present invention of the embodiment. For example, an oxide such as SiO₂, SiNx, Al₂O₃, Ta₂O₅, TiO₂, MgO, ZrO₂, CeO₂, K₂O, Li₂O, Na₂O, Rb₂O, Sc₂O₃, Y₂O₃, Hf₂O₃, CaHfO₃, PbTi₃, BaTa₂O₆, SrTiO₃, AlN or the like can be used. Among the materials, preferably, SiO₂, SiNx, Al₂O₃, Y₂O₃, Hf₂O₃, and CaHfO₃ is used. More preferably, SiO₂, SiNx, Y₂O₃, Hf₂O₃, and CaHfO₃ is used. A particularly preferable material is Y₂O₃. The oxygen number of any of the oxides may not always coincide with the stoichiometric ratio (for example, SiO₂ or SiOx may be used).
Such a gate insulating film 50 may have a structure in which two or more different insulating films are stacked. The gate insulating film 50 may be any of crystalline, polycrystalline, and amorphous materials, preferably, a polycrystalline or amorphous material for easier industrial manufacture.

In the embodiment, the transparent semiconductor thin film 40 is a thin film containing indium oxide and an oxide of a positive divalent element and is formed so that a carrier density obtained by Hall measurement becomes less than 2×10⁺¹⁷ cm⁻³.

When the carrier density becomes 2×10⁺¹⁷ cm⁻³ or higher, there is the possibility that a leak current increases. To avoid such an inconvenience more effectively, the carrier density is set to 10⁺¹⁷ cm⁻³ or less, preferably 10⁺¹⁶ cm⁻³ or less, more preferably 10⁺¹⁵ cm⁻³ or less, further more preferably 5×10⁺¹⁴ cm⁻³ or less and, particularly preferably, 3×10⁺¹⁴ cm⁻³ or less.
The lower limit of the electron carrier concentration is preferably, although it depends on a device, a circuit, or an apparatus to which an obtained oxide film is used, for example, 10⁺¹⁴/cm³ or higher.

The specific resistance of the transparent semiconductor thin film 40, which is a value obtained by the four-terminal method, is usually 10⁻¹ to 10⁸ Ωcm. When the specific resistance is lower than 10⁻¹ Ωcm, electricity flows easily, and the film may not function as a semiconductor thin film. On the other hand, when the specific resistance is higher than 10⁸ Ωm, the film may not function as a semiconductor unless a strong electric field is applied.
To avoid such an inconvenience more effectively, the specific resistance is preferably 10 to 10⁷ Ωcm, more preferably 10² to 10⁶ Ωcm and, particularly preferably, 10³ to 10⁴ Ωcm.
The thickness of the transparent semiconductor thin film 40 is usually 0.5 to 500 nm, preferably 1 to 150 nm, more preferably 3 to 80 nm, and particularly preferably 10 to 60 nm. When the thickness is smaller than 0.5 nm, it is technically difficult to form a film uniformly. On the other hand, when the thickness is larger than 500 nm, film formation time becomes long so that the method cannot be employed from the industrial viewpoint. When the thickness lies in the range of 3 to 80 nm, the TFT characteristics such as mobility and on-off ratio are particularly excellent.

By forming the transparent semiconductor thin film 40 so that the carrier density becomes less than 2×10⁺¹⁷ cm⁻³ as described above, a novel excellent field effect transistor can be obtained. The transistor has a high field effect mobility and a high on-off ratio, is normally off, has a clear pinch-off, can realize a larger area in place of a conventional field effect transistor using amorphous silicon, and has high stability.

Further, by making indium oxide contained in the transparent semiconductor thin film 40, high mobility is realized. By controlling oxygen partial pressure in the atmospheric gas at the time of film formation or the content of the water H₂O or hydrogen H₂ in the atmospheric gas, the mobility can be controlled.

In the embodiment, examples of the positive divalent element contained as an oxide in the transparent semiconductor thin film 40 include Zn, Be, Mg, Ca, Sr, Ba, Ti, V, Cr, Mn, Fe, Co, Ni, Pd, Pt, Cu, Ag, Cd, Hg, Sm, Eu, Yb, or the like. Among them, Zn, Mg, Mn, Co, Ni, Cu, and Ca are preferable. Among them, Zn, Mg, Cu, Ni, Co, and Ca are more preferable since they can control the carrier concentration efficiently. From the viewpoint of an effect of the carrier control by addition, Cu and Ni are particularly preferable. From the viewpoint of transmittance and the wideness of the band gap, Zn and Mg are particularly preferable. A combination of a plurality of elements in those positive divalent elements may be used without loosing the effects of the embodiment.
The positive divalent element is an element having a positive valence of two in an ion state.

Although the reason why it is effective to make the positive divalent element contained is not always clear, it is estimated that a part of the positive divalent element replaces a positive trivalent indium site, thereby making the resultant function as a dopant, and controlling the carrier density.
It is also estimated that, by making a positive divalent element contained in an indium as a positive trivalent element, the carrier concentration can be also controlled stably.

In the transparent semiconductor thin film 40, an element and a compound other than indium oxide and an oxide of the positive divalent element may be contained without loosing effects of the embodiment.
Normally, the indium oxide and the oxide of the positive divalent element are contained by 50% by mass or more. When the content is smaller than 50% by mass, the effects of the embodiment may not sufficiently appear and, for example, the mobility decreases.
To make the effects of the embodiment sufficient appear, the indium oxide and the oxide of the positive divalent element are contained preferably 65% by mass or greater, more preferably 80% by mass or greater, further more preferably 90% by mass or greater, and particularly preferably 95% by mass or greater.
To make the effects of the embodiment sufficient appear, the content of a positive quadrivalent element such as Sn is preferably 3% by mass or less, more preferably 2% by mass or less, and particularly preferably 1% by mass or less. When a positive quadrivalent element is contained, there is the possibility that the carrier density cannot be controlled to be low.

In the embodiment, the energy band gap between the conduction band and the valence band in the transparent semiconductor thin film 40 can be set to 2.8 eV or more.
If the energy band gap is smaller than 2.8 eV, when the film is irradiated with a visible ray, electrons in the valence band are excited, conductivity is displayed, and there is the possibility that a leak current is generated easily. To avoid such an inconvenience more effectively, the energy band gap is preferably 3.0 eV or larger, more preferably 3.1 eV or larger, and particularly preferably 3.5 eV or larger.
Although there is no upper limit of the band gap, the upper limit is usually 4.5 eV or less, preferably, 4.0 eV or less. When the band gap is too large, the carrier density becomes high. There is the possibility that leak current in a TFT increases, or the device is normally on.

The transparent semiconductor thin film 40 is preferably a crystalline film. When the semiconductor thin film 50 is an amorphous film, it may be difficult to reduce/control the carrier concentration.
The reason is estimated that the positive divalent element is solid-solution substituted by indium, and activation becomes difficult.
Further, preferably, the semiconductor thin film 50 is made of polycrystal. With the configuration, the semiconductor thin film 50 can be easily formed also on a glass substrate and an organic substrate.

The atom ratio [X/(X+In)] between indium [In] and a positive divalent element [X] contained in the semiconductor thin film 50 can be set to 0.0001 to 0.1.
When the atom ratio [X/(X+In)] is lower than 0.0001 and the content of the positive divalent element is small, it is feared that the effects of the embodiment do not appear and the number of carriers cannot be controlled.
On the other hand, when the atom ratio [X/(X+In)] becomes higher than 0.1 and the content of the positive divalent element becomes excessive, there is the possibility that the interface or surface tends to alter and becomes unstable, crystallization temperature becomes high to make crystallization difficult, the carrier concentration increases, and the Hall mobility decreases. It is also feared that, when a transistor is driven, the threshold voltage fluctuates, and driving becomes unstable.
In the embodiment, to avoid the inconveniences more effectively, the atom ratio [X/(X+In)] is preferably 0.0005 to 0.1, more preferably 0.001 to 0.099, further more preferably 0.005 to 0.095, and particularly preferably 0.01 to 0.09. The most preferable ratio is 0.01 to 0.08.

Preferably, the transparent semiconductor thin film 40 contains bixbite crystal of indium oxide. It is estimated that when at least a part of the transparent semiconductor thin film 40 employs the bixbite structure, the Hall mobility becomes high. Whether the bixbite crystal is included or not can be confirmed by X-ray diffraction.
Further preferably, in the transparent semiconductor thin film 40, a part of an indium site of the bixbite crystal of the indium oxide is solid-solution substituted by the positive divalent element. More preferably, the positive divalent element is any of zinc Zn, Mg, Cu, Ni, Co, and Ca.

In the embodiment, the film forming method for forming the transparent semiconductor thin film 40 is not limited to the chemical film forming method such as the spray method, the dipping method, or CVD method but the physical film forming method can be also used. From the viewpoint of easiness of control on the carrier density and improvement in the film quality, the physical film forming method is preferred.

As the physical film forming method, for example, sputtering, vacuum deposition, ion plating, pulse laser deposition, and the like can be mentioned. From the industrial viewpoint, sputtering realizing high mass productivity is preferable.
As the sputtering, for example, DC sputtering, RF sputtering, AC sputtering, ECR sputtering, facing target sputtering, and the like can be mentioned. Among them, DC sputtering and AC sputtering realizing high mass productivity and the carrier concentration lower than that achieved by the RF sputtering are preferred from the industrial viewpoint. To suppress degradation in the interface caused by film formation and leak current and to improve the characteristics of the transparent semiconductor thin film 40 such as on-off ratio, ECR sputtering and facing target sputtering in which the film quality can be easily controlled are preferred.
A distance between a substrate and a target (S-T distance) at the time of sputtering is usually 150 mm or less, preferably 110 mm, and particularly preferably 80 mm or less. When the S-T distance is short, the substrate is exposed to plasma at the time of sputtering, so that activation of the positive divalent element can be expected. When the S-T distance is longer than 150 mm, the film forming speed becomes low, and the method may not be suitable for industrialization.

In the case of using sputtering, a sintered target containing indium and one or more elements selected from zinc, magnesium, copper, cobalt, nickel, and calcium, and oxygen may be used or both a sintered target containing indium oxide and a sintered target containing an oxide of a positive divalent element may be used. Reactive sputtering may be performed using a metal or alloy target while introducing gas such as oxygen.
From viewpoint of reproducibility, uniformity in a large area, and characteristics of a TFT obtained, it is preferable to use a sintered target containing indium, one or more elements selected from zinc, magnesium, copper, cobalt, nickel, and calcium, and oxygen.
At the time of manufacturing a sintered target, it is preferable to perform sintering in reducing atmosphere. Further, the bulk resistance of the sintered target is preferably 0.001 to 1,000 mΩcm and, more preferably, 0.01 to 100 mΩcm. A positive divalent element to be doped may be added in the form of an oxide or metal powders at the time of manufacturing a sintered target. The sintered density of the sintered target is usually 70%, preferably 85% or higher, more preferably 95% or higher and, particularly preferably 99% or higher.

In the case of using sputtering, the ultimate pressure is usually set to 5×10⁻² Pa or less. When the ultimate pressure is higher than 5×10⁻² Pa, there is the possibility that a large amount of hydrogen atoms are supplied from H₂O and the like in the atmospheric gas, and the mobility decreases. The reason is considered that binding of the hydrogen atoms causes a change in the crystal structure of the indium oxide.
To avoid such an inconvenience more effectively, the ultimate pressure is preferably 5×10⁻³ Pa or less, more preferably 5×10⁻⁴ Pa or less, further more preferably 1×10⁻⁴ Pa or less, and particularly preferably, 5×10⁻⁵ Pa or less.

The oxygen partial pressure in the atmospheric gas is normally set to 40×10⁻³ Pa or less. When the oxygen partial pressure in the atmospheric gas is higher than 40×10⁻³ Pa, there is the possibility that the mobility decreases and the carrier concentration becomes unstable. The reason is estimated as follows. When oxygen in the atmospheric gas is excessive at the time of film formation, oxygen taken in the crystal lattice increases, and it causes scattering. The oxygen easily leaves the film, and unstableness occurs.
To avoid such inconveniences more effectively, the oxygen partial pressure in the atmospheric gas is preferably 15×10⁻³ Pa or less, more preferably 7×10⁻³ Pa or less, and particularly preferably 1×10⁻³ Pa or less.

The concentration of water H₂O or hydrogen H₂ in the atmospheric gas is usually set to 1.2 vol% or less. When the concentration is higher than 1.2 vol%, the Hall mobility may decrease. The reason is estimated that the hydrogen H binds with indium or oxygen in the bixbite structure, and an edge sharing part of the oxygen-indium bond is corner-shared.
To avoid such inconveniences more effectively, the concentration of water H₂O or hydrogen H₂ in the atmospheric gas is preferably 1.0 vol% or less, more preferably 0.1 vol% or less, and particularly preferably 0.01 vol% or less.

In such a film forming process, the transparent semiconductor thin film 40 may be formed as a film containing crystalline material by a method of forming a film containing crystalline material, or a method of forming a film and crystallizing the film or improving crystallinity in a post process.
In the method of forming a film containing crystalline material, usually, a film is formed physically at a substrate temperature of 250 to 550°C. The substrate temperature is preferably 300 to 500°C, more preferably 320 to 400°C. At 250°C or less, there is the possibility that crystallinity is low and the carrier density becomes high. At 550°C or higher, there is the possibility that cost increases and the substrate deforms.
In the method of forming a film and crystallizing the film or improving crystallinity in a post process, usually, the film is physically formed at the substrate temperature of 250°C or less. When the substrate temperature is higher than 250°C, the effect of the post process is not sufficiently displayed, and it becomes difficult to control the carrier concentration to be low and to control the mobility to be high. To avoid such an inconvenience more effectively, the substrate temperature is preferably 200°C or less, more preferably 150°C or less, further more preferably 100°C or less and, particularly preferably, 50°C or less.
The method of forming a film containing crystalline material has a simple process and is preferable from the technical viewpoint. However, to obtain high TFT characteristics, the method of forming a film and crystallizing the film in a post process is preferable for the reason that crystallinity is high, film stress is low, and carriers are controlled more easily. Although a film containing crystal may be crystallized in a post process, a method of forming an amorphous film and crystallizing the film in a post process is preferable for the reason that crystallinity is easily controlled and a semiconductor film of good quality is obtained.

. In the case of forming a film of a large area by sputtering, to provide uniformity in film quality, it is preferable to take a method of rotating a folder to which the substrate is fixed, moving a magnet to widen an erosion range, or the like.

After such a film forming process, in the embodiment, by performing an oxidizing or crystallizing process on the thin film containing indium oxide and an oxide of a positive divalent element, the carrier concentration in the transparent semiconductor thin film 40 can be controlled.
There is also a method of controlling the carrier concentration by controlling concentration of gas components such as oxygen at the time of film formation. In such a method, the Hall mobility may deteriorate. The reason is estimated that the gas components introduced for carrier control are taken in the film and become scattering factors.

Preferably, the transparent semiconductor thin film 40 is obtained by forming an amorphous film and crystallizing the amorphous film at the time of an oxidizing process. By the method, while maintaining the Hall mobility high, low carrier concentration can be realized.

As the oxidizing process or crystallizing process, heat treatment is performed normally in the presence or absence of oxygen under conditions of 80 to 650°C and 0.5 to 12000 minutes. It is preferable to perform the oxidizing process or crystallizing process in the presence of oxygen for the reason that oxygen deficiency is expected to be simultaneously reduced.
When the temperature of the heat treatment is lower than 80°C, the process effects may not appear or it may take too much time. When the temperature is higher than 650°C, there is the possibility that energy cost becomes high, tact time becomes longer, a threshold voltage when a TFT is formed becomes high, and the substrate deforms. To avoid such an inconvenience more effectively, the process temperature is preferably 120 to 500°C, more preferably 150 to 450°C, further more preferably, 180 to 350°C, and, particularly preferably, 200 to 300°C. The most preferable temperature is 220 to 290°C.
When the time of the heat treatment is shorter than 0.5 minute, time to heat to the inside is insufficient, and the heat treatment may not be performed sufficiently. When the time is longer than 12,000 minutes, the processing apparatus becomes large and may not be suitable for an industrial application. There is the possibility that the substrate is broken or deformed during the treatment. To avoid such an inconvenience more effectively, the process time is preferably 1 to 600 minutes, more preferably 5 to 360 minutes, further more preferably 15 to 240 minutes, and particularly preferably 30 to 120 minutes.

As the oxidizing process or crystallizing process, heat treatment can be performed in the presence or absence of oxygen by a lamp annealer (LA), a rapid thermal annealer (RTA), or a laser annealer. As the oxidizing process or crystallizing process, an ozone process or a radiation process using an ultraviolet ray and the like can be also applied. The methods can be combined and used in such a manner that the ozone process is performed while irradiating a film with an ultraviolet ray.
In the case of performing heat treatment, the temperature of the film surface during the heat treatment is preferably higher than the substrate temperature at the time of film formation by 100 to 270°C. When the temperature difference is smaller than 100°C, there is no heat treatment effect. When the temperature difference is larger than 270°C, there is the possibility that the substrate deforms, the semiconductor thin film interface deteriorates, and the semiconductor characteristics degrade. To avoid such an inconvenience more effectively, the temperature of the film surface in the heat treatment is higher than the substrate temperature at the time of film formation by, more preferably, 130 to 240°C and, particularly preferably, 160 to 210°C.

In the embodiment, the field effect mobility of the thin film transistor 1 is usually set to 1 cm²/Vs or higher. When the field effect mobility is lower than 1 can2/Vs, there is the possibility that the switching speed decreases. To avoid such an inconvenience more effectively, the field effect mobility is preferably 5 cm²/Vs or higher, more preferably 18 cm²/Vs or higher, further more preferably 30 cm²/Vs or higher, and particularly preferably 50 cm²/Vs or higher.
The on-off ratio of the thin film transistor 1 is usually 10³ or higher, preferably 10⁴ or higher, more preferably 10⁵ or higher, further more preferably 10⁶ or higher, and particularly preferably 10⁷ or higher.
Preferably, from the viewpoint of reduction in power consumption, the device is normally off when the threshold voltage (Vth) is positive. If the device is normally on when the threshold voltage (Vth) is negative, the power consumption may increase. The threshold voltage is usually 0.01 to 5V, preferably 0.05 to 3V, more preferably 0.1 to 2V, and further more preferably 0.2 to 1V. When the threshold voltage is higher than 5V, there is the possibility that power consumption increases. When the threshold voltage is lower than 0.01V, the device may be normally on due to fluctuations.
The ratio W/L between channel width W and channel length L of a TFT is usually 0.1 to 100, preferably 1 to 20, and more preferably 2 to 8. When W/L exceeds 100, there is the possibility that leak current increases, or the on-off ratio decreases. When it is lower than 0.1, there is the possibility that the field effect mobility decreases or a pinch-off becomes unclear.
Further, the channel length L is usually 0.1 to 1,000 µm, preferably 1 to 100 µm, and more preferably 2 to 10 µm. When the channel length L is 0.1 µm or less, it is difficult to manufacture a device from the industrial viewpoint and, in addition, a short channel effect may appear or leak current may increase. The channel length L of 1,000 µm or larger is unpreferable for the reason that the device becomes too large and the drive voltage becomes too high.
A gate voltage/drain voltage at the time of driving a TFT is usually 100V or less, preferably 50V or less, more preferably 20V or less, and further preferably 5V or less. When it is higher than 100V, power consumption increases and practicability may deteriorate.

### [Second Embodiment]

A second embodiment of the thin film transistor of the present invention will now be described.
FIG. 2 is an explanatory diagram showing outline of the second embodiment of the thin film transistor according to the present invention.

In the example of the diagram, in the thin film transistor 1, a gate insulating film B 52 and a gate insulating film A 51 are stacked in this order on the gate electrode 30 formed on the glass substrate 60 and, further, the transparent semiconductor thin film 40 is formed on the gate insulating film A 51. On both side parts of the transparent semiconductor thin film 40, the source electrode 20 and the drain electrode 10 are formed. In such a manner, the thin film transistor 1 of the bottom gate type is constructed.

In the foregoing first embodiment, the thin film transistor of the top gate type has been described. It can be a thin film transistor of the bottom gate type as in the second embodiment.

In the thin film transistor of the top gate type as in the first embodiment, there is the case where the surface (interface) of the transparent semiconductor thin film 40 deteriorates when the gate insulating film 50 is formed. To avoid the deterioration, it is preferable to form the thin film transistor of the bottom gate type as in the second embodiment. When a thin film transistor of the bottom gate type as in the second embodiment is used, there is the case that the surface (interface) of a gate insulating film (the gate insulating film A 51) deteriorates due to formation of the transparent semiconductor thin film 40. To avoid the deterioration, it is preferable to form the thin film transistor of the top gate type as in the first embodiment.

Also in the second embodiment, the transparent semiconductor thin film 40 can be formed in a manner similar to the above. The second embodiment is similar to the first embodiment except that the thin film transistor of the bottom gate type is used, so that detailed description of the other configuration will not be repeated.

### [Third Embodiment]

A third embodiment of the thin film transistor of the present invention will now be described.

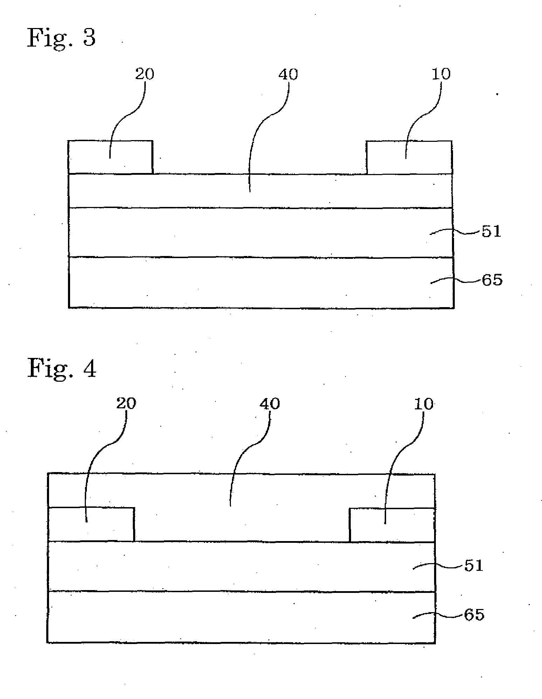

FIGS. 3 and 4 are explanatory diagrams showing outline of the third embodiment of the thin film transistor according to the present invention.

In the example shown in FIG. 3, in the thin film transistor 1, a gate insulating film 51 is stacked on a conductive silicon substrate 65 in which a gate electrode (not shown) is formed and, further, the transparent semiconductor thin film 40 is formed on the gate insulating film 51. On both side parts of the transparent semiconductor thin film 40, the source electrode 20 and the drain electrode 10 are formed. In such a manner, the thin film transistor 1 of the bottom gate type is constructed.

In the example shown in FIG. 4, in the thin film transistor 1, the gate insulating film 51 is stacked on the conductive silicon substrate 65 in which a gate electrode (not shown) is formed and, further, the source electrode 20 and the drain electrode 10 are formed on the both side of the gate insulating film 51. The transparent semiconductor thin film 40 is formed so as to sandwich the electrodes 20 and 10 in cooperation with the gate insulating film 51. In such a manner, the thin film transistor of the bottom gate type is constructed.

In the foregoing first and second embodiments, the examples of using the substrate (glass substrate) made of an insulating material have been described. As the type of a thin film transistor, a thin film transistor formed on a conductive substrate as in the third embodiment can be also employed.
Also in the third embodiment, the transparent semiconductor thin film 40 can be formed in a manner similar to the above. The third embodiment is similar to the first and second embodiments except that the thin film transistor is formed on a conductive substrate (silicon substrate), so that detailed description of the other configuration will not be repeated.

### Examples

By using concrete examples, the present invention will be described in more detail below.

### [First Example]

### (1) Manufacture and Evaluation of Sputtering Target

### 1. Manufacture of Target

As materials, indium oxide having an average particle diameter of 3.4 µm and zinc oxide having an average particle diameter of 0.6 µm were mixed so that the atom ratio [In/(In+Zn)] becomes 0.95 and the atom ratio [Zn/(In+Zn)] becomes 0.05. The mixture was supplied to a wet ball mill and mixed and ground for 72 hours to obtain material fine powders.
The obtained material fine powders were granulated and, after that, pressed to a shape having a diameter of 10 cm and a thickness of 5 mm. The resultant was put in a firing furnace and sintered under conditions of 1,400°C and 48 hours, thereby obtaining a sintered body (target). The rate of temperature rise was 3°C/minute.

### 2. Evaluation of Target

The density and a bulk resistance value of the obtained target were measured. As a result, theoretical relative density was 99% and the bulk resistance value measured by a four-terminal method was 80 mΩ.

### (2) Formation of Transparent Semiconductor Thin Film

The sputtering target obtained in (1) was loaded to a film forming apparatus using the DC magnetron sputtering method as one of the DC sputtering methods and a transparent conductive film was formed on a glass substrate (corning 1737).
Sputtering conditions were substrate temperature of 25°C, ultimate pressure of 1×10⁻³ Pa, atmospheric gas Ar of 100%, sputtering pressure (total pressure) of 4×10⁻¹ Pa, input power of 100W, film formation time of 20 minutes, and the S-T distance of 95 mm.
As a result, a transparent conductive glass in which a transparent conductive oxide having a film thickness of about 100 nm is formed on the glass substrate was obtained.
The film composition obtained was analyzed by the ICP method and found that the atom ratio [In/(In+Zn)] was 0.95 and the atom ratio [Zn/(In+zn)] was 0.05.

### (3) Process of Oxidizing Transparent Semiconductor Thin Film

An oxidizing process was performed by heating the transparent semiconductor thin film obtained in (2) in the atmosphere (in the presence of oxygen) at 300°C for 1 hour (atmosphere heat treatment).

### (4) Evaluation on Properties of Transparent Semiconductor Thin Film

The carrier concentration and Hall mobility of the transparent semiconductor thin film obtained in (3) were measured by a Hall measuring apparatus. The carrier concentration was 6×10¹⁴ cm⁻³ and the Hall mobility was 5 cm²/Vs. The specific resistance value measured by the four-terminal method was 2,100 Ωcm.

The Hall measuring apparatus and measurement conditions were as follows.

### [Hall measuring apparatus]

Resi Test8310: manufactured by TOYO Corporation

### [Measurement conditions]

Room temperature (25°C), 0.5[T], 10⁻⁴ to 10⁻¹²A, and AC magnetic field Hall measurement

Further, light transmittance of the transparent conductive oxide with respect to a light beam having a wavelength of 400 nm measured by a spectrophotometer was 85% and excellent. The energy band gap was 3.6 eV and sufficiently large.
It was confirmed that the film is polycrystalline by X-ray crystallographic analysis.

### [Examples 2 to 11 and Comparative Examples 1 to 6]

Transparent semiconductor thin films were manufactured and evaluated in a manner similar to the example 1 except that the composition ratio of materials, film forming conditions, and oxidizing process conditions were adjusted as shown in Table 1.

PAN resistance and heat resistance were also evaluated with respect to the examples and the comparative examples. Table 1 also shows transmittance and refractive index (wavelength 500 nm) of the transparent semiconductor films.

### [PAN Resistance]

In table 1, when etching rate with PAN was 10 nm/minutes or higher, "×" is shown. In the other cases, "O" is shown.
For evaluation of the PAN resistance, a PAN etchant (phosphoric acid: 91.4 wt%, nitric acid: 3.3 wt%, and acetic acid: 10.4 wt%) of 45°C was used. Usually, a PAN etchant (etchant containing phosphoric acid, nitric acid, and acetic acid) containing 20 to 95 wt% of phosphoric acid, 0.5 to 5 wt% of nitric acid, and 3 to 50 wt% of acetic acid is used.

### [Heat Resistance]

In table 1, when specific resistance becomes 1/10 or less of that before heat treatment of 260°C for one hour, "×" is shown. In the other cases, "O" is shown.

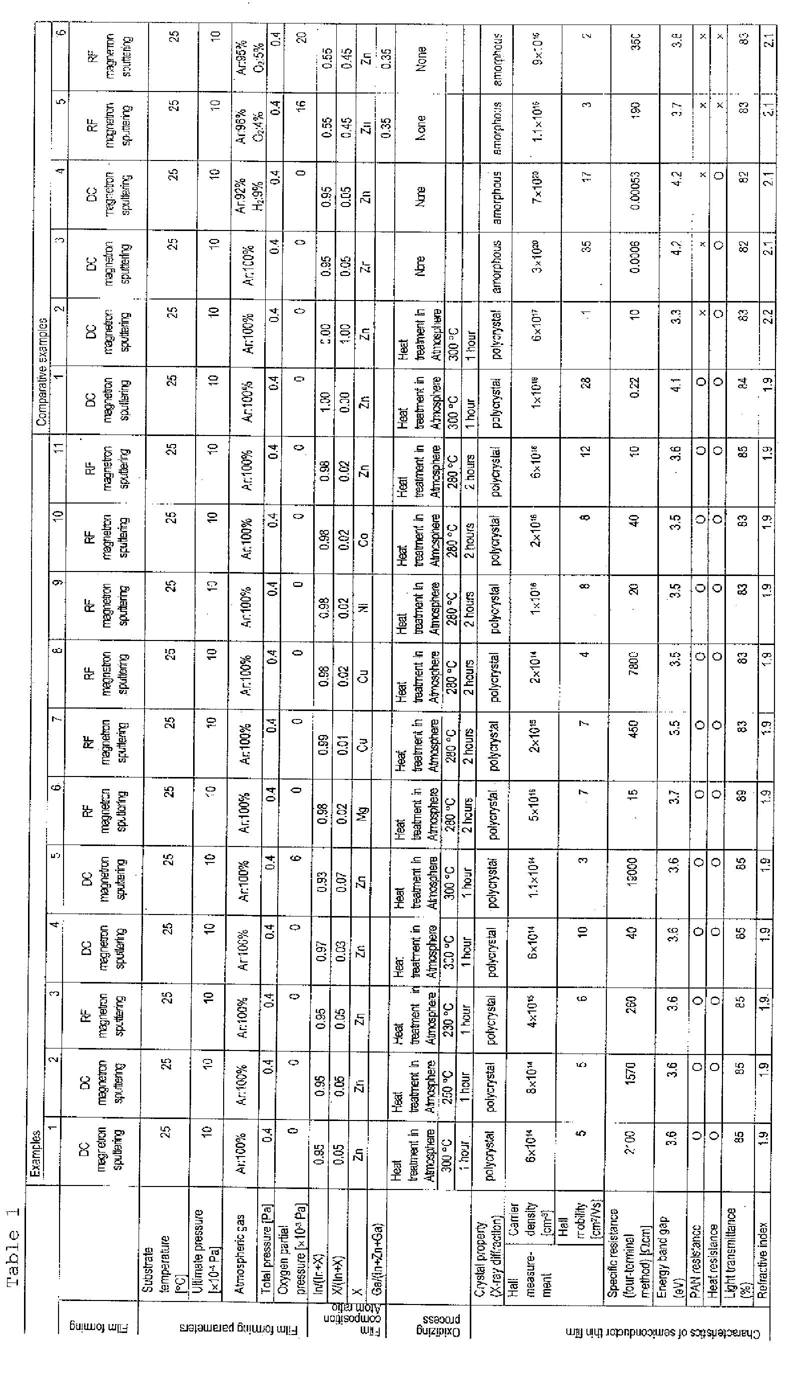

Transistors having the configurations of FIGS. 3 and 4 were manufactured using the semiconductor films of Table 1. Although the transistor characteristics were confirmed in the examples 1 to 11 and the comparative examples 2, 5, and 6, they were not confirmed in the comparative examples 1, 3, and 4.

Further, thin film transistors were manufactured and evaluated as follows using the semiconductor thin films of the examples and the comparative examples.

### [Example: Top-Gate-Type Transparent Thin Film Transistor/Insulating Substrate]

Using a transparent semiconductor thin film having 30 nm formed under the same conditions as those of the example 1 except for the film formation time, a top-gate-type thin film transistor having a channel length L = 10 µm and a channel width W = 150 µm and having a configuration as shown in FIG. 1 was constructed on a glass substrate.
As the gate insulating film, yttrium oxide having high dielectric constant was deposited to a thickness of 170 nm. Au having a thickness of 40 nm was used as a first conductive layer and Ti having a thickness of 5 nm was used as a second conductive layer in each of a gate electrode, a source electrode, and a drain electrode.

As a result, a thin film transistor having characteristics of a field effect mobility of 35 cm²/Vs, an on-off ratio of 10⁸ or higher, and a threshold voltage (Vth) of +2.0V (normally off) was obtained. A clear pinch-off was shown as an output characteristic.

### [Example: Bottom-Gate-Type Transparent Thin Film Transistor/Insulating Substrate]

A bottom-gate-type thin film transistor having a channel length L = 5 µm and a channel width W = 25 µm and having a configuration as shown in FIG. 2 was constructed on a glass substrate.
As the semiconductor thin film, a transparent semiconductor thin film of 100 nm formed under the same conditions as those of the example 1 except for the film formation time was used. CaHfOx having a thickness of 30 nm was used as a gate insulating film A. SiNx having a thickness of 340 nm was used as a gate insulating film B. Al having a thickness of 70 nm was used as each of a source electrode and a drain electrode. Ta having a thickness of 320 nm was used as a gate electrode.

As a result, a thin film transistor having characteristics of a field effect mobility of 70 cm²/Vs, an on-off ratio of 10⁷ or higher, and a threshold voltage (Vth) of +0.5V (normally off) was obtained. A clear pinch-off was shown as an output characteristic.

### [Example: Bottom-Gate-Type Transparent Thin Film Transistor/Conductive Substrate (1)]

A bottom-gate-type thin film transistor having a channel length L = 100 µm and a channel width W = 1500 µm and having a configuration as shown in FIG. 3 was constructed on a conductive silicon substrate.
As the semiconductor thin film, a transparent semiconductor thin film of 50 nm formed under the same conditions as those of the example 4 except for the film formation time was used. An SiO₂ thermally-oxidized film having a thickness of 300 nm was used as a gate insulating film. Au having a thickness of 50 nm was used as each of a source electrode and a drain electrode.

As a result, a thin film transistor having a field effect mobility of 19 cm²/Vs, an on-off ratio of 10⁶ or higher, and a normally off characteristic was obtained. A clear pinch-off was shown as an output characteristic.

### [Example: Bottom-Gate-Type Transparent Thin Film Transistor/Conductive Substrate (2)]

A bottom-gate-type thin film transistor having a channel length L = 100 µm and a channel width W = 1500 µm and having a configuration as shown in FIG. 3 was constructed on a conductive silicon substrate.
As the semiconductor thin film, a transparent semiconductor thin film of 50 nm formed under the same conditions as those of the example 11 except for the film formation time was used. An SiO₂ thermally-oxidized film having a thickness of 300 nm was used as a gate insulating film. Au having a thickness of 50 nm was used as each of a source electrode and a drain electrode.

As a result, a thin film transistor having a field effect mobility of 24 cm²/Vs, an on-off ratio of 10⁵ or higher, and a normally off characteristic was obtained. A clear pinch-off was shown as an output characteristic.

### [Example: Bottom-Gate-Type Transparent Thin Film Transistor/Conductive Substrate (3)]

A bottom-gate-type thin film transistor having a channel length L = 100 µm and a channel width W = 2000 µm and having a configuration as shown in FIG. 4 was constructed on a conductive silicon substrate.
As the semiconductor thin film, a transparent semiconductor thin film of 50 nm formed under the same conditions as those of the example 4 except for the film formation time was used. An SiO₂ thermally-oxidized film having a thickness of 300 nm was used as a gate insulating film. Au having a thickness of 50 nm was used as each of a source electrode and a drain electrode.

As a result, a thin film transistor having a field effect mobility of 10 cm²/Vs, an on-off ratio of 10⁵ or higher, and a normally off characteristic was obtained. A clear pinch-off was shown as an output characteristic.

### [Example: Bottom-Gate-Type Transparent Thin Film Transistor/Conductive Substrate (4)]

A bottom-gate-type thin film transistor having a channel length L = 100 µm and a channel width W = 2000 µm and having a configuration as shown in FIG. 4 was constructed on a conductive silicon substrate.
As the semiconductor thin film, a transparent semiconductor thin film of 20 nm formed under the same conditions as those of the example 6 except for the film formation time was used. An SiO₂ thermally-oxidized film having a thickness of 300 nm was used as a gate insulating film. Au having a thickness of 50 nm was used as each of a source electrode and a drain electrode.

As a result, a thin film transistor having a field effect mobility of 11 cm²/Vs, an on-off ratio of 10⁴ or higher, and a normally off characteristic was obtained. A clear pinch-off was shown as an output characteristic.

### [Example: Bottom-Gate-Type Transparent Thin Film Transistor/Conductive Substrate (5)]

A bottom-gate-type thin film transistor having a channel length L = 100 µm and a channel width W = 2000 µm and having a configuration as shown in FIG. 4 was constructed on a conductive silicon substrate.
As the semiconductor thin film, a transparent semiconductor thin film of 20 nm formed under the same conditions as those of the example 7 except for the film formation time was used. An SiO₂ thermally-oxidized film having a thickness of 300 nm was used as a gate insulating film. Au having a thickness of 50 nm was used as each of a source electrode and a drain electrode.

As a result, a thin film transistor having a field effect mobility of 11 cm²/Vs, an on-off ratio of 10⁶ or higher, and a normally off characteristic was obtained. A clear pinch-off was shown as an output characteristic.

### [Comparative Example: Top-Gate-Type Transparent Thin Film Transistor/Insulating Substrate]

Using a transparent semiconductor thin film formed under the same conditions as those of the comparative example 2, a top-gate-type thin film transistor having a channel length L = 10 µm and a channel width W = 150 µm and having a configuration as shown in FIG. 1 was constructed on a glass substrate.
As the gate insulating film, yttrium oxide having high dielectric constant was deposited to a thickness of 170 nm. Au having a thickness of 40 nm was used as a first conductive layer and Ti having a thickness of 5 nm was used as a second conductive layer in each of a gate electrode, a source electrode, and a drain electrode.

As a result, a thin film transistor having characteristics of a field effect mobility of 0.5 cm²/Vs, an on-off ratio of 10³, and a threshold voltage (Vth) of -0.5V (normally on) was obtained. A pinch-off was unclear as an output characteristic.

### [Comparative Example: Bottom-Gate-Type Transparent Thin Film Transistor/Insulating Substrate]

A bottom-gate-type thin film transistor having a channel length L = 5 µm and a channel width W = 25 µm and having a configuration as shown in FIG. 2 was constructed on a glass substrate. As a channel layer (transparent semiconductor thin film), a transparent semiconductor thin film of 100 nm formed under the same conditions as those of the comparative example 2 except for the film formation time was used. CaHfOx having a thickness of 30 nm was used as a gate insulating film A. SiNx having a thickness of 340 nm was used as a gate insulating film B. Al having a thickness of 70 nm was used as each of a source electrode and a drain electrode. Ta having a thickness of 320 nm was used as a gate electrode.

As a result, a thin film transistor having characteristics of a field effect mobility of 0.3 cm²/Vs, an on-off ratio of 10² or higher, and a threshold voltage (Vth) of -1.5V (normally on) was obtained. A pinch-off was unclear as an output characteristic.

### [Comparative Example: Bottom-Gate-Type Transparent Thin Film Transistor/Conductive Substrate (1)]

A bottom-gate-type thin film transistor having a channel length L = 100 µm and a channel width W = 1500 µm and having a configuration as shown in FIG. 3 was constructed on a conductive silicon substrate.
As the semiconductor thin film, a transparent semiconductor thin film of 50 nm formed under the same conditions as those of the comparative example 1 except for the film formation time was used. An SiO₂ thermally-oxidized film having a thickness of 300 nm was used as a gate insulating film. Au having a thickness of 50 nm was used as each of a source electrode and a drain electrode.

As a result, the transistor is normally on. Even when the gate voltage is changed, transistor characteristics could not be confirmed.

### [Comparative Example: Bottom-Gate-Type Transparent Thin Film Transistor/Conductive Substrate (2)]

A bottom-gate-type thin film transistor having a channel length L = 100 µm and a channel width W = 2000 µm and having a configuration as shown in FIG. 4 was constructed on a conductive silicon substrate.
As the semiconductor thin film, a transparent semiconductor thin film of 50 nm formed under the same conditions as those of the comparative example 1 except for the film formation time was used. An SiO₂ thermally-oxidized film having a thickness of 300 nm was used as a gate insulating film. Au having a thickness of 50 nm was used as each of a source electrode and a drain electrode.

As a result, the transistor is normally on. Even when the gate voltage is changed, transistor characteristics could not be confirmed.

### [Comparative Example: Bottom-Gate-Type Transparent Thin Film Transistor/Conductive Substrate (3)]

A bottom-gate-type thin film transistor having a channel length L = 100 µm and a channel width W = 1500 µm and having a configuration as shown in FIG. 3 was constructed on a conductive silicon substrate.
As the semiconductor thin film, a transparent semiconductor thin film of 50 nm formed under the same conditions as those of the comparative example 6 except for the film formation time was used. An SiO₂ thermally-oxidized film having a thickness of 300 nm was used as a gate insulating film. Au having a thickness of 50 nm was used as each of a source electrode and a drain electrode.

As a result, a thin film transistor having a field effect mobility of 8 cm²/Vs, an on-off ratio of 10⁴ or higher, and a normally off characteristic was obtained. A clear pinch-off was shown as an output characteristic.

The present invention has been described by the preferred embodiments. Obviously, the invention is not limited to the foregoing embodiments but can be variously modified in the scope of the invention.

For example, the thin film transistor has been described in the foregoing embodiments. However, the semiconductor thin film according to the invention can be applied to various field effect transistors.

For example, the semiconductor thin film of the invention is usually used in an n-type region but can be combined with various P-type semiconductors such as a P-type Si semiconductor, a P-type oxide semiconductor, and a P-type organic semiconductor and used for various semiconductor devices such as a PN-junction transistor. The TFT can be applied to various integrated circuits such as a logic circuit, a memory circuit, and a differential amplifier circuit. Further, it can be applied not only the field effect transistor but also an electrostatic induction transistor, a Schottky barrier transistor, a Schottky diode, and a resistive device.

### Industrial Applicability

The semiconductor thin film in the present invention can be widely utilized as a semiconductor thin film used for a field effect transistor such as a thin film transistor.

## Claims

1. A semiconductor thin film containing indium, a positive divalent element, and oxygen and whose specific resistance obtained by a four-terminal method is 10⁻¹ Ωm to 10⁸ Ωm.

2. The semiconductor thin film according to claim 1, wherein carrier density is less than 2x10⁺¹⁷ cm⁻³.

3. The semiconductor thin film according to claim 1 or 2, wherein the positive divalent element is one or more elements selected from zinc, magnesium, copper, cobalt, nickel, and calcium.

4. The semiconductor thin film according to any one of claims 1 to 3, wherein an energy band gap between a conduction band and a valence band is 2.8 eV or more.

5. The semiconductor thin film according to any one of claims 1 to 4, wherein the thin film is a film containing crystalline material.

6. The semiconductor thin film according to any one of claims 1 to 5, wherein atom ratio between indium [In] and a positive divalent element [X] in the thin film is expressed as X/(X+In) = 0.0001 to 0.1.

7. The semiconductor thin film according to any one of claims 1 to 6, wherein the semiconductor thin film contains bixbite crystal of indium oxide.

8. A method for producing a semiconductor thin film, comprising:
a film forming step of forming a thin film containing indium oxide and an oxide of a positive divalent element; and
a step of oxidizing or crystallizing the thin film.

9. The method for manufacturing a semiconductor thin film according to claim 8, wherein, in the oxidizing step or crystallizing step, the thin film is subject to heat treatment in the presence or absence of oxygen under conditions of 80 to 650°C and 0.5 to 12,000 minutes.

10. The method for manufacturing a semiconductor thin film according to claim 8 or 9, wherein, in the oxidizing step or crystallizing step, the thin film is subject to heat treatment in the presence or absence of oxygen by a lamp annealer (LA), a rapid thermal annealer (RTA), or a laser annealer.

11. The method for manufacturing a semiconductor thin film according to any one of claims 8 to 10, wherein the oxidizing step or crystallizing step is an ozone process.

12. The method for manufacturing a semiconductor thin film according to any one of claims 8 to 11, wherein, in the oxidizing step or crystallizing step, at least a part of the thin film is crystallized from an amorphous film to a crystalline film.

13. The method for manufacturing a semiconductor thin film according to any one of claims 8 to 12, wherein the thin film is formed physically at a substrate temperature of 200°C or less in the film forming step.

14. The method for manufacturing a semiconductor thin film according to any one of claims 8 to 13, wherein atom ratio between indium [In] and a positive divalent element [X] in the thin film is expressed as X/(X+In) = 0.0001 to 0.1.

15. A thin film transistor using the semiconductor thin film according to any one of claims 1 to 7.

16. A thin film transistor using a semiconductor thin film manufactured by the method for manufacturing a semiconductor thin film according to any one of claims 8 to 14.

17. The thin film transistor according to claim 15 or 16, wherein a device configuration is a bottom gate configuration.
